# EUROPÄISCHE PATENTANMELDUNG

(11) **EP 1 874 104 A2**
(43) Veröffentlichungstag der Anmeldung: **02.01.2008**
(21) Anmeldenummer: 07110816.1
(22) Anmeldetag: 21.06.2007
(51) Int. Cl.: H05K 5/02, H05K 7/20, H02M 7/44

(54) **Wandhalter für einen Wechselrichter einer Photovoltaikanlage und mit einem derartigen Wandhalter versehener Wechselrichter**

(30) Priorität: 21.06.2006 DE 102006028522
(71) Anmelder: Oelmaier Industrieelektronik GmbH, 88416 Ochsenhausen (DE)
(72) Erfinder: Oelmaier, Wolfgang, 88416, Ochsenhausen (DE)
(74) Vertreter: Reitstötter - Kinzebach

(57) **Zusammenfassung**

Die Erfindung betrifft einen Wandhalter für einen Wechselrichter einer Photovoltaikanlage mit Befestigungsmitteln (11,12) zur Montage des Wandhalters (10) an einer Wand oder einer Decke eines Raumes und Haltemitteln (14) zur lösbaren Aufnahme eines Wechselrichters, der dadurch gekennzeichnet ist, dass der Wandhalter (10) außerdem wenigstens eine strombetriebene Kühleinrichtung (18) zur Kühlung des Wechselrichters (30) aufweist. Der erfindungsgemäße Wandhalter kann alternativ zu herkömmlichen Wandhaltern verwendet werden und erlaubt eine aktive Kühlung von ansonsten nur passiv gekühlten Wechselrichtern.

## Beschreibung

Die Erfindung betrifft einen Wandhalter für einen Wechselrichter einer Photovoltaikanlage.

Eine Photovoltaikanlage besteht üblicherweise aus zahlreichen seriell oder parallel geschalteten Solarmodulen, die das einfallende Licht in elektrischen Strom umwandeln, der beispielsweise direkt beziehungsweise nach einer Impedanzanpassung einem elektrischen Gleichstromverbraucher zugeführt werden kann. Üblicherweise wird der von den Solarmodulen gelieferte Strom aber in das private Hausstromnetz oder, insbesondere bei größeren Anlagen, in das öffentliche Netz eingespeist. Zur Einspeisung in Wechselstromnetze oder zur Versorgung eines elektrischen Wechselstromverbrauchers muss der von den Solarmodulen gelieferte Gleichstrom jedoch zunächst in einen Wechselstrom umgewandelt werden. Dazu dient ein sogenannter Wechselrichter (DC/AC-Wandler) der zur Leistungsoptimierung üblicherweise auch mit einem sogenannten Maximum PowerPoint Tracker (MPP-Tracker) ausgerüstet ist.

Insbesondere in den Sommermonaten wird der Wechselrichter bereits durch die von den Solarmodulen gelieferte hohe Leistung sehr heiß. Die thermische Belastung des Wechselrichters wird bei ungünstiger Montage, beispielsweise an Stellen, die bei sich bei Sonneneinstrahlung stark erwärmen, wie der Dachunterseite, weiter erhöht. Eine aktive Kühlung des Wechselrichters ist aber beim Anwender häufig unbeliebt, weil in diesem Fall ein Teil der Solarenergie für die Kühlung der Elektronik des Wechselrichters abgezweigt werden muss. Daher werden Wechselrichter heute üblicherweise ohne aktive Kühlung hergestellt. Dabei wird jedoch übersehen, dass der Wechselrichter bei hoher thermischer Belastung die Stromeinspeisung ins Netz soweit reduziert, bis wieder thermisches Gleichgewicht erreicht ist. Dies kann bei ungünstigen Verhältnissen, beispielsweise an einem heißen Sommertag und/oder einer Montage des Wechselrichters im Dachstuhlbereich, zu einer Reduzierung der eingespeisten Leistung auf etwa 50% der maximal möglichen Leistung führen. In derartigen Fällen wäre eine aktive Kühlung des Wechselrichters auf jeden Fall wirtschaftlicher, da der Leistungsgewinn durch die Kühlung wesentlich größer als die für die Kühlung abgezweigte elektrische Leistung wäre.

Der Erfindung liegt daher das technische Problem zu Grunde, eine aktive Kühlung des Wechselrichters zu ermöglichen, ohne die Herstellungskosten des Wechselrichters zu erhöhen. Insbesondere hinsichtlich des letzten Punkts scheidet die Möglichkeit, ein und denselben Wechselrichter sowohl mit passiver als auch mit aktiver Kühlung anzubieten, aus wirtschaftlichen Erwägungen heraus aus.

Gelöst wird dieses technische Problem durch die Vorrichtung des vorliegenden Anspruchs 1. Vorteilhafte Weiterbildungen der erfindungsgemäßen Vorrichtung sind Gegenstände der abhängigen Ansprüche.

Die Erfindung geht von der Überlegung aus, dass für die Montage des Wechselrichters üblicherweise ein Wandhalter vorgesehen ist, der Befestigungsmittel zur Montage des Wandhalters an einer Wand oder einer Decke eines Raumes, sowie Haltemittel zur lösbaren Aufnahme des Wechselrichters aufweist. Die Erfindung schlägt nun vor, einen Wandhalter für einen Wechselrichter einer Photovoltaikanlage bereitzustellen, der eine strombetriebene Kühleinrichtung zur aktiven Kühlung des Wechselrichters aufweist. Damit besteht die Möglichkeit, flexibel auf die Wünsche der Kunden zu reagieren, ohne jeden Wechselrichter in einer rein passiven bzw. einer aktiv und passiv gekühlten Variante bereitstellen zu müssen. Der Kunde kann sich jeweils entscheiden, ob er ein und denselben Wechselrichter mit einer herkömmlichen Wandhalterung oder mit der erfindungsgemäßen Wandhalterung mit aktiver Kühleinrichtung einsetzen will.

Vorteilhaft umfasst die Kühleinrichtung Mittel zur Steuerung und Regelung der Kühlleistung der Kühleinrichtung, so dass die Kühlleistung an den momentanen Kühlbedarf angepasst werden kann, um stets eine maximale Einspeisung von Solarstrom in das angekoppelte Stromnetz zu gewährleisten.

Die Mittel zur Steuerung und Regelung der Kühlleistung umfassen wenigstens einen Temperatursensor zur Messung der Umgebungstemperatur und/oder der Temperatur des Wechselrichters. Beispielsweise kann man einen Temperatursensor vorsehen, der mit den Kühlrippen des Wechselrichters in thermischem Kontakt steht. Die Kühleinrichtung kann beispielsweise ab einer am Kühlkörper des Wechselrichters gemessenen Temperatur von 50°C in Betrieb genommen werden.

Häufig reicht eine Temperaturmessung am Kühlkörper des Wechselrichters für eine zufriedenstellende Steuerung und Regelung aus. Es ist jedoch auch möglich, gleichzeitig oder alternativ zur Messung der Temperatur des Wechselrichters die Momentanleistung des Wechselrichters zu messen und bei bekanntem Wirkungsgrad und bekannter Außentemperatur die erforderliche Kühlleistung zu errechnen.

Die Kühleinrichtung des erfindungsgemäßen Wandhalters kann über das Stromnetz oder über Batterien betrieben werden. Besonders vorteilhaft wird die Kühleinrichtung aber über den Wechselrichter mit dem von dem Solarmodul gelieferten Strom betrieben. Dazu weisen die Haltemittel zur Aufnahme des Wechselrichters vorzugsweise elektrische Verbindungsmittel zur Stromversorgung der Kühleinrichtung auf, die nach Einbau des Wechselrichters in die Haltemittel mit komplementären elektrischen Verbindungsmitteln des Wechselrichters zusammenwirken. Die elektrischen Verbindungsmittel können beispielsweise als lösbare Steckverbinder ausgebildet sein. Über die elektrischen Verbindungsmittel können auch Daten über die Temperatur des Wechselrichters oder über die Momentanleistung des Wechselrichters an die Mittel zur Steuerung und Regelung der Kühlleistung der Kühleinrichtung des Wandhalters übertragen werden.

Die Kühleinrichtung des Wandhalters kann in unterschiedlichster Weise ausgebildet sein. Beispielsweise können Peltier-Elemente vorgesehen sein, die mit dem Kühlkörper des Wechselrichters in thermischen Kontakt kommen. Besonders bevorzugt umfasst die Kühleinrichtung jedoch ein von einem Elektromotor betriebenes Kühlgebläse. Besonders bevorzugt sind pro Wandhalter zwei Kühlgebläse vorgesehen, was bei gleicher Kühlleistung gegenüber einem einzigen Gebläse einem Betrieb mit niedrigerer Drehzahl und damit eine Reduzierung der Geräuschentwicklung ermöglicht. Außerdem bieten zwei Gebläse eine gewissen Redundanz, so dass im Fall eines Defekts eines Kühlgebläses trotzdem noch aktiv gekühlt werden kann.

Gemäß einer vorteilhaften Ausführungsform des erfindungsgemäßen Wandhalters ist das Kühlgebläse unter den Haltemitteln für die Wandhalterung angeordnet, so dass die Zwangsluftführung durch das Gebläse in Richtung der aufsteigenden Heißluft am Kühlkörper des Wechselrichters erfolgt.

Gegenstand der Erfindung ist auch ein Wechselrichter für Solarmodule einer Photovoltaikanlage, der lösbar in einem wie oben definierten, erfindungsgemäßen Wandhalter montierbar ist. Der Wechselrichter weist elektrische Verbindungsmittel zur Stromversorgung der Kühleinrichtung des Wandhalters auf, welche mit komplementären elektrischen Verbindungsmitteln des Wandhalters zusammenwirken.

Die Erfindung wird im Folgenden unter Bezugnahme auf ein in der beigefügten Zeichnung dargestelltes Ausführungsbeispiel näher erläutert.

In der Zeichnung zeigt:
- Figur 1: eine perspektivische Vorderansicht einer bevorzugten Ausführungsform des erfindungsgemäßen Wandhalters;
- Figur 2: eine perspektivische Rückansicht des Wandhalters der Figur 1;
- Figur 3: eine Frontansicht des Wandhalters der Figur 1; und
- Figur 4: eine Seitenansicht des Wandhalters der Figuren 1 bis 3 mit eingebautem Wechselrichter.

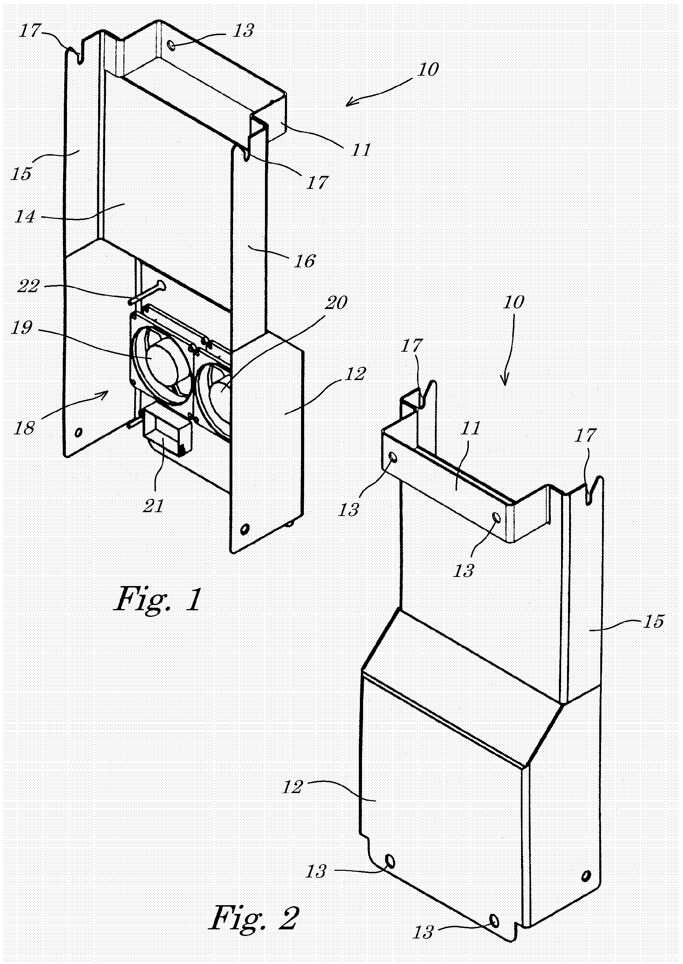

In Figur 1 ist ein insgesamt mit der Bezugsziffer 10 bezeichneter erfindungsgemäßer Wandhalter für einen Wechselrichter einer Photovoltaikanlage dargestellt. Der Wandhalter 10 weist Befestigungsmittel 11, 12 zur Montage des Wandhalters an einer Wand oder einer Decke eines Raumes auf. Im dargestellten Beispiel weisen die Befestigungsmittel Bohrungen 13 auf, über die der Wandhalter 10 mit der Wand verschraubt, oder mittels in die Bohrungen eingreifende Haken an der Wand aufgehängt werden kann. Der Wandhalter 10 weist eine als Haltemittel für den einzusetzenden Wechselrichter dienende Ausnehmung 14 auf, die im dargestellten Beispiel von Haltebügeln 15, 16 begrenzt ist, die auf ihren Oberseiten U-förmige Einschnitte 17 aufweisen, in die der Wechselrichter eingehängt werden kann.

Der Wandhalter 10 weist eine Kühleinrichtung 18 auf, die im dargestellten Beispiel aus zwei elektrisch betriebenen Kühlgebläsen 19, 20 besteht, die im unteren Bereich des Wandhalters 10 angeordnet sind. Außerdem ist eine Steuerungseinrichtung 21 vorgesehen, welche über einen Temperatursensor 22, der im eingebauten Zustand des Wechselrichters mit dem Kühlkörper des Wechselrichters in thermischem Kontakt steht, die Temperatur des Kühlkörpers misst und über die gemessene Temperatur die erforderliche Kühlleistung der Gebläse 19, 20 regelt.

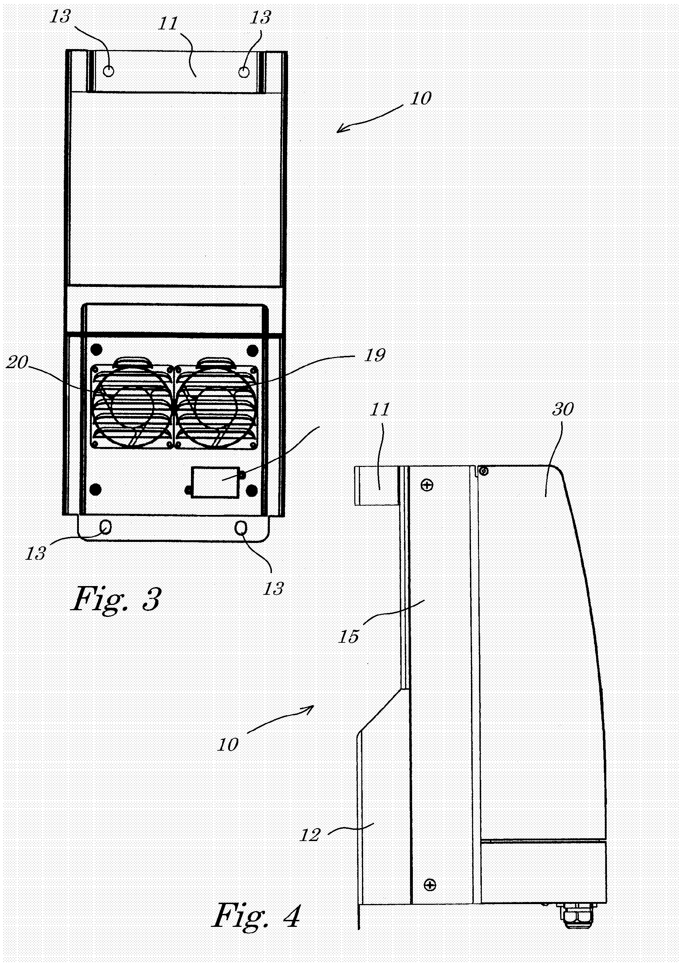

In Figur 4 ist eine Seitenansicht des Wandhalters 10 dargestellt, wobei ein schematisch angedeuteter Wechselrichter 30 in den erfindungsgemäßen Wandhalte 10 eingebaut ist.

Die beiden Kühlgebläse habe im dargestellten Beispiel eine Leistungsaufnahme von jeweils 3 Watt, was zur effektiven Kühlung eines Wechselrichters mit einer Dauerlastleistung von 5kW ausreicht. Bedenkt man, dass es im ungekühlten Betrieb des Wechselrichters zu einer Verringerung der Netzeinspeisung von 30 bis 50 % kommen kann, so wird deutlich, dass die für die aktive Kühlung erforderliche Leistung durch den Betrieb der Lüfter im Vergleich zu der durch die Kühlung verhinderten Verringerung der ins Netz eingespeisten Leistung vernachlässigt werden kann.

## Patentansprüche

1. Wandhalter für einen Wechselrichter einer Photovoltaikanlage mit
Befestigungsmitteln (11,12) zur Montage des Wandhalters (10) an einer Wand oder einer Decke eines Raumes und
Haltemitteln (14) zur lösbaren Aufnahme eines Wechselrichters
**dadurch gekennzeichnet,**
**dass** der Wandhalter (10) außerdem wenigstens eine strombetriebene Kühleinrichtung (18) zur Kühlung des Wechselrichters (30) aufweist.

2. Wandhalter gemäß Anspruch 1, **dadurch gekennzeichnet, dass** die Kühleinrichtung Mittel (21) zur Steuerung und Regelung der Kühlleistung der Kühleinrichtung umfasst.

3. Wandhalter gemäß Anspruch 2, **dadurch gekennzeichnet, dass** die Mittel (19) zur Steuerung und Regelung der Kühlleistung wenigstens einen Temperatursensor (22) zur Messung der Umgebungstemperatur und/oder der Temperatur des Wechselrichters (10) umfassen.

4. Wandhalter gemäß einem der Ansprüche 1 oder 2, **dadurch gekennzeichnet, dass** die Mittel (21) zur Steuerung der Kühlleistung wenigstens eine Einrichtung zur Erfassung der Momentanleistung des Wechselrichters umfassen.

5. Wandhalter gemäß einem der Ansprüche 1 bis 4, **dadurch gekennzeichnet, dass** die Haltemittel (14) zur Aufnahme des Wechselrichters (10) elektrische Verbindungsmittel zur Stromversorgung der Kühleinrichtung (18) aufweisen, die nach Einbau eines Wechselrichters (30) in die Haltemittel (14) mit komplementären elektrischen Verbindungsmitteln des Wechselrichters zusammenwirken.

6. Wandhalter gemäß Anspruch 5, **dadurch gekennzeichnet, dass** die elektrischen Verbindungsmittel als lösbare Steckverbinder ausgebildet sind.

7. Wandhalter gemäß einem der Ansprüche 1 bis 6, **dadurch gekennzeichnet, dass** die Kühleinrichtung (18) ein von einem Elektromotor betriebenes Kühlgebläse (19,20) umfasst.

8. Wandhalter gemäß einem der Ansprüche 2 bis 7, **dadurch gekennzeichnet, dass** das Kühlgebläse (19,20) im unteren Bereich der Wandhalterung (10) angeordnet ist.

9. Wechselrichter für Solarmodule einer Photovoltaikanlage, der lösbar in einem Wandhalter (10) nach einem der Ansprüche 1 bis 8 montiert ist.

10. Wechselrichter gemäß Anspruch 9, **dadurch gekennzeichnet, dass** der Wechselrichter (30) elektrische Verbindungsmittel zur Stromversorgung der Kühleinrichtung des Wandhalters umfasst.
